# EUROPEAN PATENT SPECIFICATION

(11) **EP 0 888 036 B1**
(45) Date of publication and mention of the grant of the patent: **05.12.2001**
(21) Application number: 98110687.5
(22) Date of filing: 10.06.1998
(51) Int. Cl.: H05K 1/18

(54) **LCD assembly with reduced thickness and method for assembling the same**
LCD Anordnung mit reduzierter Dicke und Verfahren zum Zusammenbauen
Montage d'un LCD avec épaisseur réduite et méthode pour monter

(30) Priority: 27.06.1997 KR 9728040
(43) Date of publication of application: 30.12.1998
(73) Proprietor: Samsung Electronics Co., Ltd., Suwon-city, Kyungki-do (KR)
(72) Inventor: Jung, Jae-Ik c/o SAMSUNG ELECTRONICS CO., LTD., Suwon-city Kyungki-do (KR)
(74) Representative: Grünecker, Kinkeldey, Stockmair & Schwanhäusser Anwaltssozietät

(56) References cited:
- EP-A- 0 766 505
- EP-A- 0 776 038
- US-A- 4 992 688

## Description

The present invention relates to a liquid crystal display (LCD) for use in a communication terminal, and in particular, to an LCD assembly with reduced thickness to be suitable for a communication terminal and a method for assembling the same.

In general, an LCD is widely used for a display unit of a communication terminal such as a cordless portable telephone. Such an LCD is constructed in the form of a module, and installed in a PCB (Printed Circuit Board) of the communication terminal to display various operating status of the communication terminal.

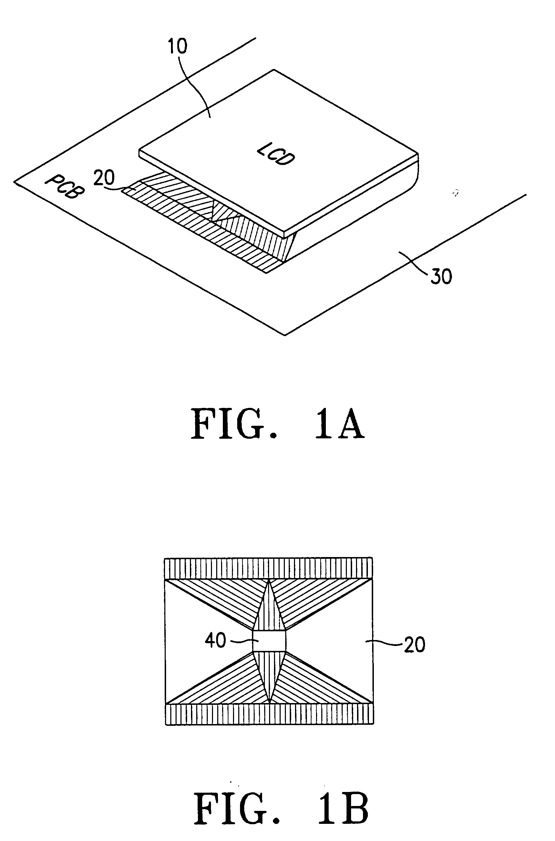

FIG. 1A illustrates a known LCD assembly in which an LCD is installed in a PCB of a portable telephone. Referring to FIG. 1A, an LCD 10 is installed in a PCB 30 using a flexible cable 20 for electrically connecting the LCD 10 to the PCB 30. The flexible cable 20 has an LCD driver 40 disposed at the center surface thereof, as shown in FIG: 1B. In general, the LCD driver 40 for driving the LCD 10 is realised by a TAB IC (Tape Automated Bonding Integrated Circuit).

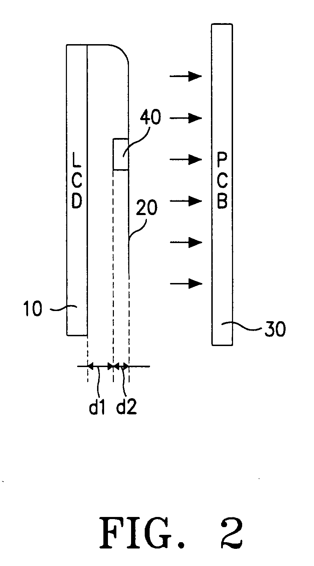

FIG: 2 is an assembling diagram showing how the LCD 10 is installed in the PCB 30 according to the prior art. Referring to FIG. 2, the LCD 10 is installed in the PCB 30 and electrically connected to the PCB 30 through the flexible cable 20. Likewise, the flexible cable 20 has the LCD driver 40 disposed at the center surface thereof, facing to the backside of the LCD 10. The reason that the flexible cable 20 is used in connecting the LCD 10 to the PCB 30 is because the flexible cable 20 is freely bendable toward the backside of the LCD 10, thereby reducing the thickness of the LCD Assembly. Here, it is noted that the LCD driver 40 is disposed at a center surface of the flexible cable 20, facing to the backside of the LCD 10. Accordingly, in installing the LCD 10 in the PCB 30, the LCD assembly needs a width d2 of the LCD driver 40 plus an extra space d1 between the LCD driver 40 and the LCD 10, needed in some applications to secure a space between LCD and PCB. In practice, in order to offer the extra space d1, guides (not shown) are attached to a side where the LCD 10 is connected to the flexible cable 20 and its opposite side, i.e., to both ends of the LCD 10.

To sum up, the conventional LCD assembly needs at least the width d2 of the LCD driver 40 to install the LCD 10 in the PCB 30, so that the communication terminal having the LCD assembly becomes undesirably thick.

European Patent No. 0 776 038 A2 discloses an LCD assembly where the LCD driver is mounted in a hollow portion or a through hole of the PCB. However, a hollow portion or through hole of the PCB in Figure 2 does not allow for the desired reduction of the overall assembly thickness, since the driver is facing towards the LCD.

It is therefore an object of the present invention to provide an LCD assembly using a flexible cable connecting the LCD to the PCB with reduced thickness to be suitable for a communication terminal using an LCD as a display unit, and a method for assembling the same.

To achieve the above object, there is provided an inventive method comprising the features of claim 1 and LCD assembly comprising the features of claim 3. Preferable embodiments are a subject matter of the dependent claims.

This measure provides a significantly reduced thickness of the LCD assembly, since the LCD driver is at least partly located within the recess.

The above object and advantages of the present invention will become more apparent by describing in detail preferred embodiments thereof with reference to the attached drawings in which:
- FIG. 1A: is a diagram illustrating a known LCD assembly in which an LCD is installed in a PCB;
- FIG. 1B: is a top view illustrating a flexible cable (/20) of FIG. 1A, having an LCD driver (40) at a center surface thereof;
- FIG. 2: is an assembling diagram showing how to install the LCD in the PCB according to the prior art;
- FIG. 3A: is an assembling diagram showing how to install an LCD in a PCB according to an embodiment of the present invention; and
- FIG. 3B: is a diagram illustrating an LCD assembly in which the LCD is installed in the PCB according to the embodiment of the present invention.

A Preferred embodiment of the present invention will be described in detail referring to the attached drawings, in which the like reference numerals denote the same elements in the drawings, for understanding. Though the specific embodiment will be exemplarily defined and described in detail to clarify the subject matter of the present invention, the present invention may be implemented with the description of the present invention by those skilled in the art even without the details. In addition, an unnecessary detailed description of widely known functions and constructions may be avoided here.

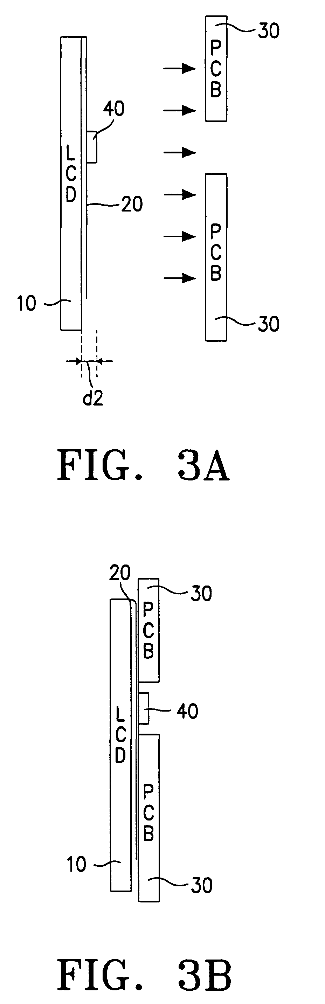

FIG. 3A illustrates how to install the LCD 10 in the PCB 30 according to an embodiment of the present invention, and FIG. 3B illustrates an LCD assembly according to the present invention. As mentioned above, this LCD assembly can be used for a communication terminal such as a portable telephone.

Referring to FIG. 3A, the flexible cable 20 is interposed between the backside of the LCD 10 and the front side of the PCB 30, being bent inward at an end portion connected to the LCD 10, and electrically connects the LCD 10 to the PCB 30. The LCD driver 40 for driving the LCD 10 is disposed at a specific place, preferably, at the center surface of flexible cable 20, facing to the front side of the PCB 30. For example, a TAB IC 6F-F02 manufactured by Samsung Electronics Co. can be used for the LCD driver 40. The PCB 30 has a through hole formed at a position corresponding to where the LCD driver 40 is disposed. The LCD driver 40 is inserted into the through hole formed in the PCB 30, so that the thickness of the LCD assembly may be minimised. In practice, a large-sized element such as an LSI (Large Scale IC) chip can be disposed at the opposite side of the PCB 30, covering the through hole. In this case, there is no limitation in utilising the surfaces of the PCB 30.

The LCD assembly does not need the extra space d1 between the LCD 10 and the LCD 40. That is, the LCD assembly according to the present invention can reduce the extra space d1 which was needed in the conventional LCD assembly, by disposing the LCD driver 40 at the opposite side of the flexible cable 20.

FIG. 3B illustrates the LCD assembly in which the LCD 10 is installed in the PCB 30 according to the embodiment of the present invention. As illustrated, the LCD driver 40 is inserted into the through hole formed in the PCB 30, thereby minimising the thickness of the LCD assembly. Actually, when assembled, the LCD assembly according to the present invention has the thickness of the LCD 10 plus the thickness of the PCB 30, thus reducing the extra space d1. On the contrary, however, the conventional LCD assembly has (the thickness of the LCD 10) + (the thickness of the PCB 30) + (the thickness d2 of the LCD driver 40 ) + (the extra space d1). For example, in the ordinary portable telephone, the thickness of the LCD driver 40 is about 0.4 mm, and the extra space d1 is about 0.6 - 0.8 mm. Accordingly, if the LCD assembly according to the present invention is applied to the portable telephone, the thickness of the portable telephone can be reduced by 1.0 -1.2 mm.

As described above, by changing a position where the LCD driver is disposed and inserting the LCD driver into the through hole formed at the corresponding place where the LCD driver is disposed, the thickness of the LCD assembly can be reduced by 1.0 - 1.2 mm in maximum. Therefore, it is possible to reduce the thickness of the portable telephone, thereby offering a great convenience to the user.

Although illustrative embodiments of the present invention have been described herein with reference to the accompanying drawings, it is to be understood that the invention is not limited to those precise embodiments, and that various other changes and modifications may be affected therein by one skilled in the art without departing from the scope of the invention.

## Claims

1. Method for installing an LCD (Liquid Crystal Display) (10) and an LCD driver (40) for driving said LCD in a PCB (Printed Circuit Board) (30), comprising the steps of:
using a flexible cable (20) for electrically connecting the LCD (10) to the PCB (30);
disposing said LCD driver (40) for driving said LCD (10) at a specific place on said flexible cable (20), causing the LCD driver (40) to face to said PCB (30);
forming a recess in the PCB (30) at a position corresponding to where said LCD driver (40) is disposed; and
inserting said LCD driver (40) at least partly into said recess.

2. Method as defined in claim 1,
**characterized in that**
said recess is formed as a through hole in the PCB.

3. LCD assembly comprising:
an LCD (Liquid Crystal Display) (10),
an LCD driver (40) for driving said LCD, and
a PCB (Printed Circuit Board) (30), wherein said LCD driver (40) is at least partly located in a recess formed in said PCB (30),
**characterized in that**
said LCD driver (40) is disposed at a specific place on a flexible cable (20) that is used to electrically connect the LCD (10) to the PCB (30), facing to the front side of the PCB (30).

4. LCD assembly as claimed in claim 3,
**characterized in that**
said recess is formed as a through hole in said PCB (30).

5. LCD assembly as claimed in claim 3 or 4,
**characterized in that**
said flexible cable is interposed between a backside of said LCD (10) and the front side of said PCB (30) and being bent inward at an end portion connected to said LCD (10).

6. LCD assembly as claimed in any of the claims 3 to 5,
**characterized in that**
said LCD driver (40) is disposed at a center surface of the flexible cable (20).

## Patentansprüche

1. Verfahren für die Montage einer LCD (Flüssigkristallanzeige) (10) und eines LCD-Treibers (40) zur Ansteuerung der LCD in eine PCB (gedruckte Schaltung) (30) umfassend die Schritte:
Verwendung eines flexiblen Kabels (20), um die LCD (10) mit der PCB (30) elektrisch zu verbinden;
Anordnen des LCD Treibers (40) zur Ansteuerung der LCD (10) an einer bestimmten Stelle auf dem flexiblen Kabel (20), wobei der LCD Treiber (40) gegenüber der PCB (30) angeordnet ist;
Bilden einer Vertiefung in die PCB (30) entsprechend an einer Stelle, an der der LCD Treiber (40) angeordnet wird; und
Einfügen des LCD Treibers (40) zumindest teilweise in die Vertiefung.

2. Verfahren nach Anspruch 1,
**dadurch gekennzeichnet, dass**
die Vertiefung als durchgehendes Loch in der PCB ausgebildet ist.

3. LCD Anordnung umfassend:
eine LCD (Flüssigkristallanzeige) (10),
einen LCD Treiber (40) zur Ansteuerung der LCD, und eine PCB (gedruckte Schaltung) (30), worin der LCD Treiber (40) zumindest teilweise in einer Vertiefung liegt, die in der PCB (30) ausgebildet ist,
**dadurch gekennzeichnet, dass**
der LCD Treiber (40) an einem speziellen Ort auf dem flexiblen Kabel (20), das verwendet wird, um die LCD (10) mit der PCB (30) elektrisch zu verbinden, angeordnet ist, wobei die Vorderseite der PCB (30) gegenüberliegt.

4. LCD Anordnung nach Anspruch 3,
**dadurch gekennzeichnet, dass**,
die Vertiefung als durchgehendes Loch in der PCB (30) ausgebildet ist.

5. LCD Anordnung nach Anspruch 3 oder 4,
**dadurch gekennzeichnet, dass**,
das flexible Kabel zwischen der Rückseite der LCD (10) und der Vorderseite der PCB (30) angeordnet ist und an dem Endabschnitt, der mit der LCD (10) verbunden ist, nach innen gebogen wird.

6. LCD Anordnung nach jedem der Ansprüche 3 - 5,
**dadurch gekennzeichnet, dass**,
der LCD Treiber (40) in der Mitte an der Oberfläche des flexiblen Kabels (20) angeordnet ist.

## Revendications

1. Procédé pour installer un affichage à cristaux liquides (10) et un dispositif d'attaque d'affichage à cristaux liquides (40) pour attaquer ledit affichage à cristaux liquides dans une carte de circuits imprimés (30), comprenant les étapes suivantes :
l'utilisation d'un câble souple (20) pour connecter électriquement l'affichage à cristaux liquides (10) à la carte de circuits imprimés (30) ;
la disposition dudit dispositif d'attaque d'affichage à cristaux liquides (40) pour attaquer ledit affichage à cristaux liquides (10) en un emplacement spécifique sur ledit câble souple (20), de façon à faire en sorte que le dispositif d'attaque d'affichage à cristaux liquides (40) fasse face à ladite carte de circuits imprimés (30) ;
la formation d'une cavité dans la carte de circuits imprimés (30) en une position correspondant à l'endroit où est disposé ledit dispositif d'attaque d'affichage à cristaux liquides (40) ; et
l'insertion dudit dispositif d'attaque d'affichage à cristaux liquides (40) au moins partiellement dans ladite cavité.

2. Procédé selon la revendication 1, **caractérisé en ce que** :
ladite cavité est formée par un trou traversant dans la carte de circuits imprimés.

3. Ensemble d'affichage à cristaux liquides comprenant :
un affichage à cristaux liquides (10),
un dispositif d'attaque d'affichage à cristaux liquides (40) pour attaquer ledit affichage à cristaux liquides, et
une carte de circuits imprimés (30), dans lequel ledit dispositif d'attaque d'affichage à cristaux liquides (40) est au moins partiellement disposé dans une cavité formée dans ladite carte de circuits imprimés (30),
**caractérisé en ce que** :
ledit dispositif d'attaque d'affichage à cristaux liquides (40) est disposé en un emplacement spécifique sur un câble souple (20) qui est utilisé pour connecter électriquement l'affichage à cristaux liquides (10) à la carte de circuits imprimés (30), faisant face à la face avant de la carte de circuits imprimés (30).

4. Ensemble d'affichage à cristaux liquides selon la revendication 3, **caractérisé en ce que** :
ladite cavité est formée par un trou traversant dans ladite carte de circuits imprimés (30).

5. Ensemble d'affichage à cristaux liquides selon la revendication 3 ou 4, **caractérisé en ce que** :
ledit câble souple est interposé entre une face arrière dudit affichage à cristaux liquides (10) et la face avant de ladite carte de circuits imprimés (30) et est incurvé vers l'intérieur en une position d'extrémité connectée audit affichage à cristaux liquides (10).

6. Ensemble d'affichage à cristaux liquides selon l'une quelconque des revendications 3 à 5, **caractérisé en ce que** :
ledit dispositif d'attaque d'affichage à cristaux liquides (40) est disposé sur une surface centrale du câble souple (20).
